# FASCICULE DE BREVET EUROPEEN

(11) **EP 0 595 671 B1**
(45) Date de publication et mention de la délivrance du brevet: **08.01.1997**
(21) Numéro de dépôt: 93402419.1
(22) Date de dépôt: 04.10.1993
(51) Int. Cl.: B23K 1/20

(54) **Procédé et dispositif de fluxage par voie sèche**
Trockenflussverfahren- und Vorrichtung
Dry reflow process and apparatus

(30) Priorité: 30.10.1992 FR 9213028
(43) Date de publication de la demande: 04.05.1994
(73) Titulaire: L'AIR LIQUIDE, SOCIETE ANONYME POUR L'ETUDE ET L'EXPLOITATION DES PROCEDES GEORGES CLAUDE, F-75321 Paris Cédex 07 (FR)
(72) Inventeur: Sindzingre, Thierry, F-94230 Cachan (FR); Mellul, Sylvie, F-94400 Vitry (FR); Duchateau, Eric, F-78000 Versailles (FR)
(74) Mandataire: Le Moenner, Gabriel

(56) Documents cités:
- EP-A- 0 371 693
- EP-A- 0 427 020
- EP-A- 0 518 774
- GB-A- 2 072 430

## Description

La présente invention concerne un procédé et un dispositif pour le fluxage par voie sèche d'au moins une surface d'un article métallique, notamment en vue de son brasage ou de son étamage.

Le brasage d'articles métalliques, notamment le brasage de composants électroniques à la surface d'un support métallique, tel un circuit imprimé, est habituellement effectué industriellement selon deux méthodes principales : le brasage à la vague et le brasage par refusion.

La méthode du brasage à la vague peut également être utilisée pour étamer des articles métalliques, notamment les parties métalliques des composants électroniques.

En vue du brasage ou de l'étamage d'un article métallique par la méthode du brasage à la vague, les parties métalliques dudit article devant être mouillées par la brasure sont généralement fluxées au moyen d'un flux. Celui-ci est constitué de composés organiques, notamment des acides organiques et des dérivés halogénés.

Le fluxage a pour objectif essentiel le décapage des surfaces métalliques, principalement pour en éliminer les oxydes métalliques, en vue de faciliter et d'améliorer la qualité de leur mouillage par la brasure.

Après passage sur la vague de brasage, des résidus de flux persistent sur les surfaces métalliques traitées. Ces résidus de flux étant corrosifs et conducteurs, ils sont éliminés lors d'une opération de nettoyage utilisant habituellement des solvants halogénés, en particulier des chlorofluorocarbones (CFC).

Le brasage par refusion consiste à déposer une pâte à braser sur des plages d'accueil localisées à la surface d'un support, à mettre en contact des articles métalliques, tels des composants électroniques, avec la pâte à braser, puis à chauffer la pâte à braser par refusion, notamment au moyen d'infrarouges, par convection, en phase vapeur, par une association d'infrarouges et de convection, par exemple dans un four de refusion.

La pâte à braser comporte une poudre d'alliage métallique dispersée dans un milieu organique comprenant un flux. Ce flux est lui aussi constitué habituellement d'acides organiques et de dérivés halogénés, et a le même rôle de décapage des surfaces métalliques.

Après chauffage de la pâte à braser, ici encore, des résidus de flux persistent à la surface du support, qui induisent les mêmes inconvénients que ceux décrits plus haut. Comme dans le cas du brasage à la vague, il convient d'éliminer ces résidus par une opération de nettoyage, mettant généralement en oeuvre des CFC.

Dans le contexte du protocole de Montréal visant à éliminer la production des CFC, diverses solutions ont été envisagées en vue de supprimer leur utilisation dans le nettoyage des résidus de flux, aussi bien dans le cas du brasage à la vague que dans celui du brasage par refusion.

Parmi ces solutions, on peut citer la méthode dite "non nettoyage" qui consiste à mettre en oeuvre des flux "faibles résidus" dont les formulations sont modifiées de sorte à minimiser la quantité de résidus de flux. Mais on a pu constater que des quantités de résidus de flux non négligeables demeuraient présentes sur les surfaces des articles métalliques traités.

C'est pourquoi il a également été proposé d'autres méthodes dites de "fluxage par voie sèche" qui consistent à traiter les surfaces à fluxer au moyen d'une phase gazeuse. La phase gazeuse réagit au niveau des surfaces traitées notamment de façon à former des produits de réaction volatils qui sont éliminés lors du renouvellement de la phase gazeuse.

Ainsi, M.W. Liebfried a proposé au congrès ISHM Europe à Hambourg (1989), un fluxage par voie sèche, utilisant une phase gazeuse constituée d'un mélange d'azote et d'acide formique, obtenue en faisant barboter de l'azote dans un réservoir d'acide formique. Cependant, l'acide formique, dans les conditions de mise en oeuvre, pose des problèmes de sécurité importants.

La demande de brevet EP-371.693 décrit un procédé et un dispositif de brasage conformes aux préambules des revendications 1,16,20 mettant également en oeuvre un fluxage par voie sèche. Selon ce procédé, on place un échantillon à traiter sur un porte-substrat chauffant porté à une température adéquate pour fondre une brasure, l'échantillon et le porte-substrat étant disposés dans un réacteur basse pression.

On fait régner dans le réacteur une pression très faible, de l'ordre de 10⁻⁵ Torr (133.10⁻⁵ Pa). Cette basse pression est obtenue par une pompe à diffusion et une pompe primaire. Puis on introduit dans le réacteur une atmosphère constituée d'hydrogène et d'argon, à une pression de 10 à 100 mTorr (1,330 à 13,30 Pa), à partir de laquelle on forme un plasma au moyen d'énergie micro-ondes, ce plasma permettant d'éliminer les oxydes métalliques. Ce procédé présente l'inconvénient majeur de faire appel à une installation pour l'obtention d'un vide secondaire, ce qui le rend très difficilement utilisable à l'échelle industrielle. De plus, à basse pression, les transferts thermiques par rayonnement sont en général prépondérants, de sorte que des fours tels des fours à parois chaudes, ne sauraient être convenablement utilisés et devraient être remplacés par des systèmes radiants plus coûteux.

La présente invention concerne alors un procédé et des dispositifs obviant aux inconvénients mentionnés ci-dessus des procédés de fluxage par voie sèche, et en particulier, ne nécessitant pas la mise en oeuvre d'un vide poussé et ne posant pas de problèmes de sécurité.

L'invention consiste en un procédé de fluxage par voie sèche d'au moins une surface d'un article métallique, procédé dans lequel on traite la surface à fluxer par un plasma d'un mélange gazeux constitué d'hydrogène et éventuellement d'au moins un gaz inerte, caractérisé en ce que le plasma est à la pression atmosphérique. Un tel plasma contient de l'hydrogène atomique.

Il a été constaté que d'une manière surprenante, le procédé de fluxage par voie sèche de l'invention, utilisant un plasma contenant de l'hydrogène atomique, à la pression atmosphérique, peut être utilisé pour, notamment, éliminer les oxydes métalliques présents sur les surfaces traitées, celà de manière au moins aussi efficace que lorsqu'on utilise un plasma à très basse pression. Un tel procédé peut donc être facilement mis en oeuvre à l'échelle industrielle.

L'invention est à présent décrite plus en détail, à l'aide des figures jointes.

Ledit gaz inerte constitutif du plasma peut être de l'azote, de l'hélium ou, de préférence, de l'argon.

La concentration en hydrogène dans le mélange gazeux peut être comprise entre 0,01 % et 100 % en volume, de préférence comprise entre 0,5 et 50 % en volume.

On peut traiter la surface à fluxer par le plasma à une température inférieure à 300°C, de préférence comprise entre l'ambiante et 200°C, plus préférentiellement entre 110°C et 180°C.

Dans le cadre du procédé de l'invention, on peut créer le plasma en excitant, à la pression atmosphérique, un mélange gazeux constitué d'hydrogène et d'éventuellement au moins un gaz inerte, par des micro-ondes, produite par un générateur de micro-ondes. Ce plasma micro-ondes peut présenter l'aspect d'une décharge luminescente.

On peut également créer le plasma en excitant, à la pression atmosphérique, un mélange gazeux constitué d'hydrogène et d'éventuellement au moins un gaz inerte par une décharge électrique à barrière diélectrique.

La décharge électrique à barrière diélectrique consiste à produire une décharge électrique entre deux électrodes, dont l'une au moins est recouverte d'un matériau diélectrique, tels le verre, l'alumine, la silice ou un polymère. Une telle décharge peut notamment consister en une décharge luminescente ou "silent glow discharge" ou, de préférence, dans le cadre de l'invention, en une décharge couronne.

La décharge couronne est une décharge classique bien connue en elle-même, cf. l'article "Traitement par effet corona, considérations techniques sur l'équipement" de G. Tuffin paru dans "Plastiques Modernes et Elastomères", mai 1977, pages 54-56, qui donnent des indications sur le matériel à utiliser et les conditions opératoires.

Une décharge couronne se produit entre deux électrodes dont les rayons de courbure diffèrent fortement. A titre d'exemple, une électrode peut être en forme de cylindre, l'autre étant plane. Dans le cadre de l'invention, l'une des deux électrodes peut être constituée par ledit article métallique lui-même. Une haute tension peut être appliquée entre les électrodes. Cette haute tension peut être comprise entre 1 et 50 kV, avec une fréquence comprise entre le continu et 100 kHz.

Selon un aspect de l'invention, la surface de l'article métallique peut être recouverte par une couche dudit matériau diélectrique, dans laquelle on a dégagé une lumière mettant à jour une partie de la surface de l'article métallique à traiter.

Cette lumière peut être réalisée de sorte qu'elle soit située en vis-à-vis de l'une des électrodes. Mais, de préférence, en vue d'obtenir une décharge couronne plus stable, la lumière dans la couche du matériau diélectrique est réalisée latéralement à distance, par exemple de 1 à 5 cm, de la position en vis-à-vis de l'électrode, décrite ci-dessus. De cette façon, la décharge couronne se propage à la surface de la couche en matériau diélectrique, jusqu'à la lumière, où elle rencontre la surface de l'article métallique à fluxer. On obtient ainsi une décharge couronne dite "transférée", particulièrement stable.

L'invention concerne également des dispositifs pouvant notamment être utilisés pour la mise en oeuvre du procédé décrit plus haut.

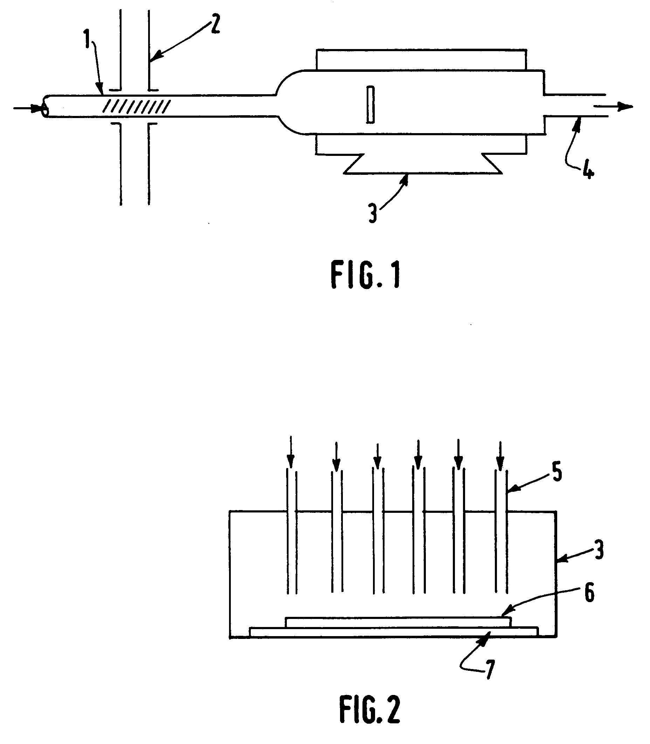

La figure 1 représente une vue en coupe d'un dispositif pour le fluxage d'un article métallique au moyen d'un plasma micro-ondes. Ce dispositif comporte un tube 1 d'alimentation en gaz. Le tube d'alimentation 1 peut être est en un matériau diélectrique, généralement en quartz. Le tube d'alimentation 1 traverse un guide d'ondes 2, disposé perpendiculairement audit tube d'alimentation. Le guide d'ondes 2 est relié à un générateur de micro-ondes (non représenté). Le tube d'alimentation 1 débouche dans un four 3, par exemple un four Adamel, pourvu d'un tube d'extraction 4.

En fonctionnement, on place un article métallique à fluxer dans le four 3 et on y introduit en continu un mélange gazeux contenant de l'hydrogène et éventuellement au moins un gaz inerte, par le tube d'alimentation 1, selon un débit déterminé. Le plasma se forme dans le tube d'alimentation 1, au niveau de la zone d'intersection avec le guide d'ondes 2. Puis des espèces constitutives du plasma, notamment l'hydrogène atomique, diffusent dans le four, de sorte à fluxer l'article métallique.

La figure 2 représente la section d'un autre dispositif pour le fluxage par voie sèche au moyen d'un plasma micro-ondes, à la pression atmosphérique.

Ce dispositif est une variante de celui représenté à la figure 1, mais est plus particulièrement adapté à une application à l'échelle industrielle. Ce dispositif comporte un four 3 dans lequel débouche une rangée de tubes 5 d'alimentation en gaz, muni de guides d'ondes (non représentés).

La partie des tubes d'alimentation représentée à la figure 2 est celle faisant suite à la zone d'intersection avec les guides d'ondes. L'article métallique traité, par exemple une plaque métallique 6, est convoyé dans le four au moyen d'une bande de défilement 7.

Le fonctionnement de ce dispositif est similaire à celui représenté à la figure 1. Il permet de traiter des articles métalliques de formes et de dimensions variées.

Si une rangée de tubes d'alimentation 5, munis de guides d'ondes, ne suffit pas pour effectuer le traitement désiré, plusieurs de ces rangées peuvent être associées en série.

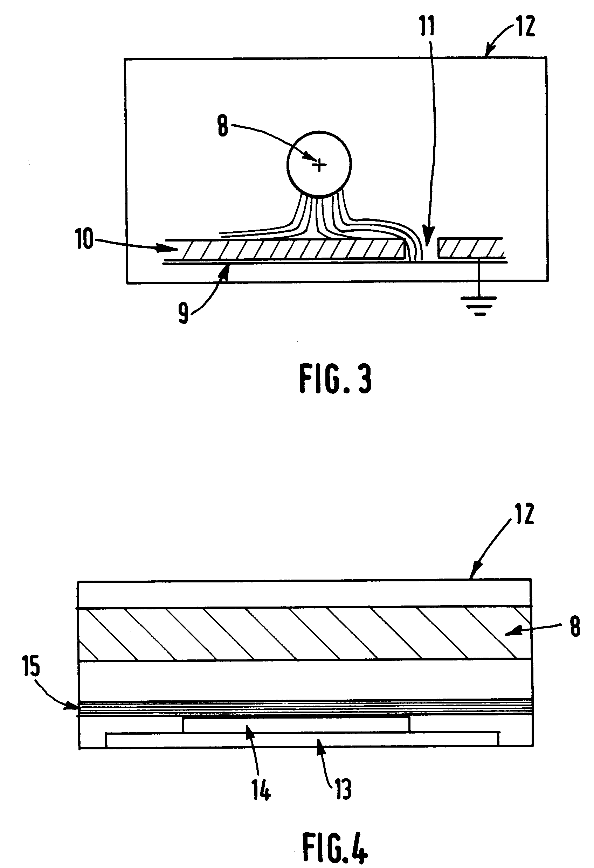

La figure 3 représente une coupe d'un dispositif pour le fluxage d'un article métallique au moyen d'un plasma créé par décharge couronne transférée.

Ce dispositif comporte, dans une enceinte 12 pourvue d'un tube d'alimentation en gaz (non représenté), une électrode haute tension 8 de forme cylindrique et une deuxième électrode 9, consistant ici en une plaque métallique reliée à la terre. Cette plaque métallique est ici l'article métallique à traiter. Une couche en un matériau diélectrique 10 est disposée au-dessus de l'électrode 9. Ladite couche présente une lumière 11 placée latéralement à distance de l'électrode 8. Cette lumière met à jour la partie de la surface de l'article métallique à fluxer.

Ce dispositif fonctionne de la manière suivante : on applique une tension entre les électrodes 8 et 9 de sorte à créer une décharge couronne transférée, qui va s'étaler sur la surface de la couche en matériau diélectrique, puis sur la partie de la surface de l'électrode 9 mise à jour par la lumière 11. Parallèlement, on introduit dans l'enceinte 12, au moyen du tube d'alimentation un mélange gazeux contenant de l'hydrogène et éventuellement au moins un gaz inerte. Ce mélange gazeux va être excité par la décharge couronne et former un plasma contenant de l'hydrogène atomique. Ce plasma va fluxer la partie de l'article métallique formant l'électrode 9, dégagée par la lumière 11.

La figure 4 représente la section d'un dispositif pour fluxage par voie sèche, à la pression atmosphérique. Ce dispositif est une variante de celui représenté à la figure 3, mais est plus particulièrement adapté à une application industrielle.

Ce dispositif comporte une enceinte 12, tel un four, dans laquelle est placée une électrode haute tension 8, par exemple de forme cylindrique, disposée au-dessus d'une bande de défilement 13 formant électrode. L'article métallique 14 à traiter est disposé sur la bande de défilement 13. Une couche en matériau diélectrique 15, fixe dans l'enceinte, est disposée au-dessus de la bande de défilement 13 à une distance suffisante pour permettre le défilement de l'article métallique 14. Dans cette couche 15, une lumière, (non représentée) a été dégagée latéralement à distance de l'électrode haute tension 8. La longueur de la lumière peut être égale à celle de l'électrode 8. Le mode de fonctionnement de ce dispositif est similaire à celui du dispositif de la figure 3.

Comme l'article métallique à traiter est entraîné sous la lumière sur toute sa longueur par la bande de défilement, on peut le fluxer sur une plus grande surface. Il est possible de disposer en parallèle plusieurs électrodes haute tension 8 dans l'enceinte 12 et de dégager autant de lumières dans la couche en matériau diélectrique, chacune de ces lumières étant située latéralement à distance de l'électrode lui correspondant.

L'invention concerne également un procédé de brasage ou d'étamage d'au moins une surface d'un article métallique selon lequel, préalablement à l'opération de brasage ou d'étamage, ladite surface est fluxée selon le procédé décrit ci-dessus. Pendant l'opération de brasage ou d'étamage, ledit article peut être porté à une température inférieure ou égale à 200°C, généralement à une température comprise entre 180°C et 200°C.

L'opération de brasage ou d'étamage peut être réalisée classiquement selon la méthode de brasage à la vague.

L'opération de brasage peut également être réalisée, classiquement, par refusion. Dans ce dernier cas, la pâte à braser mise en oeuvre peut, de manière connue, comporter une poudre d'un alliage métallique, tels des alliages plomb- étain, plomb-étain-argent ou plomb-indium, dispersée dans un milieu organique. Ce dernier peut comporter au moins un solvant organique, au moins un agent épaississant et/ou au moins une résine, telle une résine colophanique. En outre, le milieu organique peut comporter un flux à base d'activateurs de fluxage, généralement des composés organiques, comme des acides organiques et/ou des dérivés halogénés. Cependant, dans la mesure où l'une au moins des surfaces de l'article métallique à braser a été fluxée selon le procédé décrit plus haut, la teneur en flux dudit milieu organique peut être notablement diminuée, de sorte à minimiser les résidus de flux laissés sur ladite surface après brasage. Plus avantageusement encore, le milieu organique constitutif de la pâte à braser peut être totalement exempt de flux.

Les procédés de fluxage et, le cas échéant, de brasage ou d'étamage, selon l'invention, sont plus particulièrement destinés au traitement d'articles métalliques tels, ou constitutifs de sept composants électroniques, comme des transistors, des résistances, des capacités, des circuits intégrés ou de supports pour de tels composants électroniques, comme des circuits imprimés.

Les exemples suivants ont pour but d'illustrer la présente invention.

### Exemple 1

On met en oeuvre un dispositif tel que représenté à la figure 1, en vue de fluxer les surfaces d'une plaque de cuivre oxydée en surface, de dimensions 20 mm/20 mm/1 m.

Le tube d'alimentation 1 en quartz présente un diamètre de 4 mm au niveau du guide d'ondes. Le diamètre du tube 1 est élargi à 5 cm avant l'entrée du four 3 et se prolonge sur toute la longueur du four pour former une enceinte dans laquelle on dépose la plaque de cuivre oxydée. Le four 3 est un four Adamel à moufle céramique cylindrique entourant ladite enceinte.

On introduit dans le tube 5 un mélange gazeux constitué de 97 % en volume d'argon et 3 % en volume d'hydrogène, sous un débit de 10 l/minute. A partir de ce mélange gazeux, on crée un plasma contenant de l'hydrogène atomique au moyen de micro-ondes propagé par le guide d'ondes 2. La puissance injectée dans le plasma est de 200 W. La plaque de cuivre est chauffée à 150°C.

Les surfaces de la plaque de cuivre peuvent ainsi être réduites en moins de deux minutes.

### Exemple 2 :

On met en oeuvre un dispositif tel que représenté à la figure 3 pour fluxer une plaque de cuivre oxydée en surface. Cette plaque de cuivre forme l'électrode 9. Elle est recouverte d'une couche de silicone diélectrique, dans laquelle on a dégagé une lumière de 1 cm², mettant à jour une surface de 1 cm² de la plaque de cuivre. Cette lumière est disposée à 1 cm de distance du vis-à-vis de l'électrode haute tension 8.

On applique une tension de 20 kV entre les électrodes, avec une fréquence de 15 kHz. Puis, pour créer une décharge couronne transférée, on introduit dans l'enceinte 12 un mélange gazeux constitué de 98 % en volume d'argon et 2 % en volume d'hydrogène, sous un débit de 4 l/minute.

L'excitation du mélange gazeux permet de créer un plasma contenant de l'hydrogène atomique autorisant une réduction, à la température ambiante, de la surface de la plaque à traiter mise à jour par la lumière 11.

## Revendications

1. Procédé de fluxage par voie sèche d'au moins une surface d'un article métallique, procédé dans lequel on traite la surface à fluxer par un plasma obtenu à partir d'un mélange gazeux comprenant de l'hydrogène et éventuellement au moins un gaz inerte, caractérisé en ce que le plasma est à la pression atmosphérique.

2. Procédé selon la revendication 1, caractérisé en ce que le gaz inerte est l'azote ou l'hélium.

3. Procédé selon la revendication 1, caractérisé en ce que le gaz inerte est l'argon.

4. Procédé selon l'une des revendications précédentes, caractérisé en ce que la concentration de l'hydrogène dans le mélange gazeux est comprise entre 0,01 % et 100 %, en volume, de préférence entre 0,5 et 50 % en volume.

5. Procédé selon l'une des revendications précédentes, caractérisé en ce qu'on traite la surface à fluxer à une température inférieure à 300°C, de préférence à une température comprise entre la température ambiante et 200°C.

6. Procédé selon l'une des revendications précédentes, caractérisé en ce qu'on crée le plasma en excitant, à la pression atmosphérique, un mélange gazeux comprenant de l'hydrogène et éventuellement au moins un gaz inerte, par des micro-ondes.

7. Procédé selon l'une des revendications 1 à 5, caractérisé en ce qu'on crée le plasma en excitant, à la pression atmosphérique, un mélange gazeux comprenant de l'hydrogène et éventuellement au moins un gaz inerte, par une décharge électrique à barrière diélectrique.

8. Procédé selon la revendication 7, caractérisé en ce que ladite décharge électrique est une décharge couronne.

9. Procédé selon l'une des revendications 7 et 8, caractérisé en ce que la décharge diélectrique est une décharge couronne transférée.

10. Procédé de brasage ou d'étamage d'au moins une surface d'un article métallique, comportant une opération de fluxage préalable, caractérisé en ce que, préalablement à l'opération de brasage ou d'étamage, ladite surface est fluxée selon le procédé de l'une des revendications 1 à 9.

11. Procédé selon la revendication 10, caractérisé en ce que l'opération de brasage ou d'étamage est réalisée selon la méthode du brasage à la vague.

12. Procédé selon la revendication 10, caractérisé en ce que l'opération de brasage est réalisée par brasage par refusion.

13. Procédé selon l'une des revendications 10 à 12, caractérisé en ce que l'article métallique est porté à une température inférieure ou égale à 200°C pendant l'opération de brasage ou d'étamage.

14. Procédé selon la revendication 13, caractérisé en ce que l'article métallique est porté à une température comprise entre 180°C et 200°C pendant l'opération de brasage ou d'étamage.

15. Procédé selon l'une des revendications 1 à 14, caractérisé en ce que l'article métallique est un composant électronique ou un support pour composants électroniques, tel un circuit imprimé.

16. Dispositif pour créer une décharge couronne, notamment pour la mise en oeuvre du procédé selon l'une des revendications 1 à 9, comportant une enceinte (12) pourvue d'un tube d'alimentation en gaz, le dispositif étant caractérisé en ce qu'il comporte au moins une électrode haute tension (8) et une deuxième électrode (9, 13) sur laquelle est disposée une couche en un matériau diélectrique (10, 15) présentant au moins une lumière (11) placée latéralement à distance de ladite électrode (8), de façon à ce que la décharge couronne créée soit transférée.

17. Dispositif selon la revendication 16, caractérisé en ce que ladite deuxième électrode est une bande de défilement (13).

18. Dispositif selon la revendication 16, caractérisé en ce que ladite deuxième électrode est constituée par un article métallique à traiter dans l'enceinte.

19. Dispositif selon l'une des revendications 16 à 18, caractérisé en ce que la couche en matériau diélectrique (15) est fixe dans l'enceinte.

20. Dispositif pour créer une décharge couronne, notamment pour la mise en oeuvre du procédé selon l'une des revendications 1 à 9, comportant une enceinte (12) pourvue d'un tube d'alimentation en gaz, le dispositif étant caractérisé en ce qu'il comporte :
- au moins-une électrode haute tension (8) ;
- une deuxième électrode constituée par une bande de défilement (13) pour la circulation de circuits électroniques dont les plages métalliques, sur lesquelles les composants électroniques seront brasés, doivent être fluxées ;
- une couche en un matériau diélectrique (15), fixe dans l'enceinte, disposée au-dessus de la bande de défilement, à une distance suffisante pour permettre le défilement de circuits électroniques, couche dans laquelle a été dégagée au moins une lumière (11) placée latéralement à distance de ladite électrode (8), cette lumière permettant le fluxage d'au moins une des plages métalliques de chacun desdits circuits, de façon à ce que la décharge couronne créée soit transférée.

## Claims

1. Method of dry fluxing at least one surface of a metallic article, a method in which the surface to be fluxed is treated with a plasma obtained from a gaseous mixture comprising hydrogen and optionally at least one inert gas, characterised in that the plasma is at atmospheric pressure.

2. Method according to Claim 1, characterised in that the inert gas is nitrogen or helium.

3. Method according to Claim 1, characterised in that the inert gas is argon.

4. Method according to one of the preceding claims, characterised in that the concentration of hydrogen in the gaseous mixture is between 0.01% and 100% by volume, and preferably between 0.5 and 50% by volume.

5. Method according to one of the preceding claims, characterised in that the surface to be fluxed is treated at a temperature below 300°C, preferably at a temperature between room temperature and 200°C.

6. Method according to one of the preceding claims, characterised in that the plasma is created by exciting, at atmospheric pressure, a gaseous mixture comprising hydrogen and optionally at least one inert gas, by means of microwaves.

7. Method according to one of Claims 1 to 5, characterised in that the plasma is created by exciting, at atmospheric pressure, a gaseous mixture comprising hydrogen and optionally at least one inert gas, by means of electrical discharge with dielectric barrier.

8. Method according to Claim 7, characterised in that the said electrical discharge is a corona discharge.

9. Method according to one of claims 7 and 8, characterised in that the dielectric discharge is a transferred corona discharge.

10. Method of soldering or tinning at least one surface of a metallic article, including a prior fluxing operation, characterised in that, prior to the soldering or tinning operation, the said surface is fluxed according to the method of one of Claims 1 to 9.

11. Method according to Claim 10, characterised in that the soldering or tinning operation is carried out according to the wave soldering method.

12. Method according to Claim 10, characterised in that the soldering operation is carried out by reflow soldering.

13. Method according to one of Claims 10 to 12, characterised in that the metallic article is brought to a temperature less than or equal to 200°C during the soldering or tinning operation.

14. Method according to Claim 13, characterised in that the metallic article is brought to a temperature between 180°C and 200°C during the soldering or tinning operation.

15. Method according to one of Claims 1 to 14, characterised in that the metallic article is an electronic component or a support for electronic components, such as a printed circuit.

16. Device for creating a corona discharge, notably for the implementation of the method according to one of Claims 1 to 9, having an enclosure (12) provided with a gas supply tube, the device being characterised in that it has at least one high-voltage electrode (8) and a second electrode (9, 13) on which is disposed a layer of dielectric material (10, 15) having at least one hole (11) placed laterally away from the said electrode (8) so that the corona discharge created is transferred.

17. Device according to Claim 16, characterised in that the said second electrode is a conveyor belt.

18. Device according to Claim 16, characterised in that the said second electrode consists of a metallic article to be treated in the enclosure.

19. Device according to one of Claims 16 to 18, characterised in that the layer of dielectric material (15) is fixed in the enclosure.

20. Device for creating a corona discharge, notably for the implementation of the method according to one of Claims 1 to 9, having an enclosure (12) provided with a gas supply tube, the device being characterised in that it has:
- at least one high-voltage electrode (8);
- a second electrode consisting of a conveyor belt (13) for the circulation of electronic circuits whose metallic areas, onto which the electronic components will be soldered, are to be fluxed;
- a layer of dielectric material (15), fixed in the enclosure, disposed above the conveyor belt, at a sufficient distance to allow the electronic circuits to pass, a layer in which at least one hole (11) has been left, placed laterally away from the said electrode (8), this hole allowing the fluxing of at least one of the metallic areas of each of the said circuits, so that the corona discharge created is transferred.

## Patentansprüche

1. Verfahren zum trockenen Behandeln zumindest einer Fläche eines Metallteils mit Flußmittel, bei dem die zu fluxende Fläche mit einem aus einem Wasserstoff und gegebenenfalls zumindest ein Inertgas enthaltenden Gasgemisch gewonnenen Plasma behandelt wird, dadurch gekennzeichnet, daß das Plasma atmosphärischem Druck hat.

2. Verfahren nach Anspruch 1, dadurch gekennzeichnet, daß das Inertgas Stickstoff oder Helium ist.

3. Verfahren nach Anspruch 1, dadurch gekennzeichnet, daß das Inertgas Argon ist.

4. Verfahren nach einem der vorangehenden Ansprüche, dadurch gekennzeichnet, daß die Wasserstoffkonzentration in dem Gasgemisch zwischen 0,01 und 100 Volumenprozent und bevorzugt zwischen 0,5 und 50 Volumenprozent beträgt.

5. Verfahren nach einem der vorangehenden Ansprüche, dadurch gekennzeichnet, daß die zu fluxende Fläche bei einer Temperatur kleiner als 300°C und bevorzugt bei einer Temperatur zwischen der Umgebungstemperatur und 200°C behandelt wird.

6. Verfahren nach einem der vorangehenden Ansprüche, dadurch gekennzeichnet, daß das Plasma bei atmosphärischem Druck durch Anregen eines Wasserstoff und gegebenenfalls zumindest ein Inertgas enthaltenen Gasgemischs mittels Mikrowellen erzeugt wird.

7. Verfahren nach einem der Ansprüche 1 bis 5, dadurch gekennzeichnet, daß das Plasma bei atmosphärischem Druck durch Anregen eines Wasserstoff und gegebenenfalls zumindest ein Inertgas enthaltenen Gasgemischs durch elektrische Entladung an einer dielektrischen Schicht erzeugt wird.

8. Verfahren nach Anspruch 7, dadurch gekennzeichnet, daß die elektrische Entladung eine Koronaentladung ist.

9. Verfahren nach einem der Ansprüche 7 oder 8, dadurch gekennzeichnet, daß die elektrische Entladung eine übertragene Koronaentladung ist.

10. Verfahren zum Löten oder Verzinnen zumindest einer Fläche eines Metallteils, umfassend eine vorangehende Flußmittelbehandlung, dadurch gekennzeichnet, daß die Fläche vor dem Löt- oder Verzinnvorgang gemäß dem Verfahren nach einem der Ansprüche 1 bis 9 gefluxt wird.

11. Verfahren nach Anspruch 10, dadurch gekennzeichnet, daß der Löt- oder Verzinnvorgang nach dem Schwall-Lötverfahren erfolgt.

12. Verfahren nach Anspruch 10, dadurch gekennzeichnet, daß der Lötvorgang durch Löten im Aufschmelzverfahren erfolgt.

13. Verfahren nach einem der Ansprüche 10 bis 12, dadurch gekennzeichnet, daß das Metallteil während des Löt- oder Verzinnvorgangs auf eine Temperatur kleiner als oder gleich 200°C gebracht wird.

14. Verfahren nach Anspruch 13, dadurch gekennzeichnet, daß das Metallteil während des Löt- oder Verzinnvorgangs auf eine Temperatur zwischen 180°C und 200°C gebracht wird.

15. Verfahren nach einem der Ansprüche 1 bis 14, dadurch gekennzeichnet, daß das Metallteil ein elektronisches Bauteil oder ein Träger für elektronische Bauteile, beispielsweise eine gedruckte Schaltung, ist.

16. Vorrichtung zum Erzeugen einer Koronaentladung insbesondere zur Anwendung des Verfahrens nach einem der Ansprüche 1 bis 9, umfassend eine mit einem Gaszufuhrrohr versehenen Kammer (12), wobei die Vorrichtung gekennzeichnet ist durch zumindest eine Hochspannungselektrode (8) und eine zweite Elektrode (9, 13), auf welcher eine Schicht aus einem dielektrischen Material (10, 15) angeordnet ist, die zumindest eine seitlich zu der vorgenannten Elektrode (8) so beabstandet angeordnete Öffnung (11) aufweist, daß die erzeugte Koronaentladung übertragen wird.

17. Vorrichtung nach Anspruch 16, dadurch gekennzeichnet, daß die zweite Elektrode ein Laufband (13) ist.

18. Vorrichtung nach Anspruch 16, dadurch gekennzeichnet, daß die zweite Elektrode aus einem in der Kammer zu behandelnden Metallteil besteht.

19. Vorrichtung nach einem der Ansprüche 16 bis 18, dadurch gekennzeichnet, daß die Schicht aus dielektrischem Material (15) in der Kammer befestigt ist.

20. Vorrichtung zum Erzeugen einer Koronaentladung insbesondere zur Anwendung des Verfahrens nach einem der Ansprüche 1 bis 9, umfassend eine mit einem Gaszufuhrrohr versehene Kammer (12), wobei die Vorrichtung gekennzeichnet ist durch:
- zumindest eine Hochspannungselektrode (8);
- eine zweite Elektrode, bestehend aus einem Laufband (13) für den Transport elektronischer Schaltkreise, deren Bereiche aus Metall, auf welche die elektronischen Bauteile gelötet werden, gefluxt werden müssen;
- eine in der Kammer befestigte Schicht aus einem dielektrischen Material (15), die in einem Abstand über dem Laufband angeordnet ist, der so bemessen ist, daß die elektronischen Schaltkreise vorbeilaufen können, und in der zumindest eine seitlich zu der vorgenannten Elektrode (8) beabstandet angeordnete Öffnung (11) so freigeschnitten ist, daß die erzeugte Koronaentladung übertragen wird, wobei diese Öffnung die Flußmittelbehandlung zumindest eines der Bereiche aus Metall jedes der Schaltkreise erlaubt.
